# EUROPEAN PATENT SPECIFICATION

(11) **EP 1 775 754 B1**
(45) Date of publication and mention of the grant of the patent: **25.03.2009**
(21) Application number: 06021231.3
(22) Date of filing: 10.10.2006
(51) Int. Cl.: H01L 21/00, B01F 15/04, B01F 3/08

(54) **Process system and process liquid supply method**
Ein Flüssigkeitslieferungssystem und -verfahren
Un système et un procédé pour fournir du liquide

(30) Priority: 11.10.2005 JP 2005296953
(43) Date of publication of application: 18.04.2007
(60) Divisional application: 08162953.7
(73) Proprietor: TOKYO ELECTRON LIMITED, Tokyo-to (JP)
(72) Inventor: Yamamoto, Shu, Koshi-shi, Kumamoto-ken (JP); Chouno, Yasuhiro, Koshi-shi, Kumamoto-ken (JP); Tokuno, Yoshichika, Koshi-shi, Kumamoto-ken (JP)
(74) Representative: HOFFMANN EITLE

(56) References cited:
- JP-A- 9 260 330
- JP-A- 2000 218 143
- US-A- 2002 154 567
- US-A1- 2004 094 089
- US-A1- 2004 110 394

## Description

### FIELD OF THE INVENTION

The present invention relates to a process system and a process liquid supply method.

### BACKGROUND OF THE INVENTION

When semiconductor parts, flat display panels, electronic parts, and so on are manufactured, objects to be processed, such as semiconductor wafers, liquid crystal substrates, and disk-shaped storage mediums, have been conventionally subjected to a cleaning process, an etching process, and so on, by means of a process system.

The conventional process system includes: a substrate processing apparatus for processing an object to be processed by a process liquid; and a process liquid supply apparatus for producing a process liquid and supplying the same to the substrate processing apparatus. The substrate processing apparatus performs various processes, such as a cleaning process and a drying process, to an object to be processed, with the use of the process liquid discharged from a process liquid outlet port. In the process system, the process liquid supply apparatus and the substrate processing apparatus are disposed integrally or separately.

The process liquid supply apparatus includes: a plurality of solution supply sources for storing solutions (stock solutions), such as a chemical liquid and a deionized water; a blending tank connected to the respective solution supply sources via weighers; and a supply tank connected to the blending tank. The supply tank of the process liquid supply apparatus is connected to a process liquid outlet port of the substrate processing apparatus (see, for example, JP9-260330A).

In the process liquid supply apparatus of the conventional process system, solutions stored in the respective solution supply sources are respectively weighed by the weighers, the weighed solutions are supplied to the blending tank where the plurality of solutions are blended to produce a process liquid of a predetermined concentration, the process liquid is temporarily stored in the supply tank, and the process liquid is supplied to the substrate processing apparatus through the process liquid outlet port according to need. Thereafter, an object to be processed is processed in the substrate processing apparatus, by using the process liquid discharged from the process liquid outlet port.

The conventional process system is disadvantageous in that a desired process effect may not be obtained, when objects to be processed are processed one after another, by using the process liquid stored in the supply tank whose concentration has been lowered because of a long process operation or the like. In order to prevent this situation, an alarm is given to the operator to inform him/her of the lowering of the concentration of the process liquid, and the process operation is stopped to discard all the process liquid stored in the supply tank. Thereafter, the process liquid of a predetermined concentration, which has been newly prepared in the blending tank, is again supplied to the supply tank.

In the above conventional process system, when the concentration of the process liquid stored in the supply tank is lowered, the process operation is stopped to discard all the process liquid stored in the supply tank, and the process liquid of a predetermined concentration, which has been newly prepared in the blending tank, is again supplied to the supply tank. That is, the process operation has to be interrupted for a long period of time before the new prepared process liquid is supplied to the supply tank, for each time the concentration of the process liquid is lowered. Thus, there has been concern that a period required for an entire process of the object to be processed is elongated, thereby reducing a throughput of the process system.

In addition, in the conventional process system, all the process liquid whose concentration has been lowered is discarded. This causes a fear of wasting a large amount of the process liquid, and consuming increased amounts of the solutions such as a chemical liquid and a deionized water, which results in increase in running costs required for the process.

US Patent Application 2004/0110394 A1 discloses the coating thickness and uniformity of spin-on deposition layers on semiconductor wafers being controlled through the in situ control of the viscosity and homogeneity of the mixture of precursor material and solvent material. The thickness of the deposited material is selected and the viscosity required at a given spin rate for the selected thickness is automatically mixed. Sensing and control apparatus are employed to ensure that the uniformity and viscosity required is maintained before dispensing onto said semiconductor wafer. Low-K dielectric materials of selected thickness are deposited in a uniform coating.

The present invention has been made in view of the above respects. The object of the present invention is to provide a process system and a process liquid supply method, that are capable of improving a throughput of a process step, without interrupting a process operation when a concentration of a process liquid has changed, and are capable of reducing running costs by decreasing the frequency of disposal of the process liquid.

US Patent Application 2002/0154567 A1 discloses a physically compact (saline) solution preparation apparatus including a solution mixing tank coupled to sources of concentrate and diluent. A concentrate transport path is configured to both homogenize and deliver concentrate to the mixing tank, while the diluent transport path is controllably purged of potential contaminates prior to supplying the diluent to the mixing tank. A mixed solution transport path recirculates and thereby homogenizes the contents of the mixing container, and actively pumps out solution that has been mixed to a prescribed conductivity-based concentration, to one or more solution on demand storage reservoirs for respective instruments. The operation of the apparatus is based upon measured conductivity of the contents of the solution mixing tank, so that there is no need to conduct precursor volumetric measurements of either diluent or concentrate.

### SUMMARY OF THE INVENTION

According to a first aspect, the present invention consists in a process system comprising a plurality of solution supply sources; a blending tank to be supplied with solutions from the respective solution supply sources, and operable to blend the solutions to produce a process liquid of a predetermined concentration; a supply tank that is connected to the blending tank operable to store therein the process liquid supplied from the blending tank; a process liquid supply adjusting valve disposed between the blending tank and the supply tank, operable to adjust a flow of the process liquid from the blending tank to the supply tank; and a process liquid discharge port to be supplied with process liquid supplied from the supply tank, and operable to discharge the process liquid toward an object to be processed; the system being characterized by comprising a judging unit operable to judge whether a concentration of the process liquid in the supply tank has changed or not; a control unit configured to control the process liquid supply adjusting valve to additionally supply the process liquid from the blending tank to the supply tank at the time of being judged by the judging unit that the concentration of the process liquid in the supply tank has changed; and a concentration sensor operable to measure the concentration of the process liquid in the supply tank, wherein the judging unit is operable to judge whether the concentration of the process liquid has changed or not, based on the concentration of the process liquid measured by the concentration sensor.

In the process system, it is preferable that the judging unit judges that the concentration of the process liquid in the supply tank has changed, when a predetermined period of time has elapsed after the flow of the process liquid from the blending tank to the supply tank was stopped by the process liquid supply adjusting valve.

In the process system, it is preferable that the supply tank is provided with a level sensor for detecting that a liquid surface level of the process liquid stored in the supply tank reaches a predetermined level; and the control unit controls such that a predetermined amount of the process liquid in the supply tank is discarded and controls the process liquid supply adjusting valve such that the process liquid is supplied from the blending tank to the supply tank until the level sensor detects that the liquid surface level of the process liquid reaches the predetermined level, when it is judged by the judging unit that the concentration of the process liquid in the supply tank has changed.

In the process system, it is preferable that further comprising: a solution supply line that connects the solution supply source and the supply tank to each other; a solution supply adjusting valve disposed on the solution supply line, that adjusts a flow of the solution from the solution supply source to the supply tank; wherein the control unit controls the solution supply adjusting valve such that, when the number of times the process liquid is additionally supplied from the blending tank to the supply tank reaches the predetermined number of times, the solution is directly supplied from the solution supply source to the supply tank.

In the process system, it is preferable that the control unit controls such that the process liquids in the blending tank and the supply tank are discarded and controls such that the process liquid is newly produced in the blending tank to supply the new process liquid to the supply tank, when a predetermined period of time has elapsed after the process liquid was produced in the blending tank.

In the process system, it is preferable that the control unit controls such the process liquids in the blending tank and the supply tank are discarded and controls such that the process liquid is newly produced in the blending tank to supply the new process liquid to the supply tank, when the number of times the process liquid is additionally supplied from the blending tank to the supply tank reaches the predetermined number of times.

According to a second aspect, the present invention consists in a process liquid supply method comprising the steps of producing a process liquid of a predetermined concentration in a blending tank by blending solutions respectively supplied from a plurality of solution supply sources; supplying the process liquid from the blending tank to a supply tank to store therein the process liquid; and discharging the process liquid from a process liquid discharge port toward an object to be processed, by supplying the process liquid to the process liquid discharge port; the method being characterized by comprising the steps of judging whether a concentration of the process liquid in the supply tank has changed or not; and supplying additionally the process liquid from the blending tank to the supply tank, when it is judged that the concentration of the process liquid in the supply tank has changed the step of preparing a concentration sensor that measures the concentration of the process liquid in the supply tank, wherein whether the concentration of the process liquid has changed or not is judged based on the concentration of the process liquid measured by the concentration sensor.

In the process liquid supply method, it is preferable that when a predetermined period of time has elapsed after a flow of the process liquid from the blending tank to the supply tank is stopped, it is judged that the concentration of the process liquid in the supply tank has changed.

In the process liquid supply method, it is preferable that when it is judged that the concentration of the process liquid in the supply tank has changed, a predetermined amount of the process liquid in the supply tank is discharged, and the process liquid is additionally supplied from the blending tank to the supply tank.

In the process liquid supply method, it is preferable that when the number of times the process liquid is additionally supplied from the blending tank to the supply tank reaches the predetermined number of times, the solution is directly supplied from the solution supply source to the supply tank.

In the process liquid supply method, it is preferable that when a predetermined period of time has elapsed after the process liquid was produced in the blending tank, the process liquids in the blending tank and the supply tank are discarded, and the process liquid is newly produced in the blending tank to supply the new process liquid to the supply tank.

In the process liquid supply method, it is preferable that when the number of times the process liquid is additionally supplied from the blending tank to the supply tank reaches the predetermined number of times, the process liquids in the blending tank and the supply tank are discarded, and the process liquid is newly produced in the blending tank to supply the new process liquid to the supply tank.

The present invention produces the following effects.

That is, in the present invention, when it is judged that a concentration of a process liquid in a supply tank has changed, the process liquid is additionally supplied from a blending tank to the supply tank. Thus, when the concentration of the process liquid has changed, interruption of the process operation can be avoided, whereby a throughput of the process step can be improved. When the concentration of the process liquid has changed, the addition of the process liquid enables that the concentration of the process liquid is maintained within a predetermined range. Thus, the frequency of disposal of the process liquid can be decreased, which results in reduction in running costs of a process system.

In addition, in the present invention, a solution supply source is directly connected to the supply tank. When it is judged that the concentration of the process liquid has changed, a solution is directly added from the solution supply source to the supply tank. Thus, when the concentration of the process liquid has changed, interruption o the process operation can be avoided, whereby a throughput of the process step can be improved. When the concentration of the process liquid has changed, the addition of the solution enables that the concentration of the process liquid is maintained within a predetermined range for a long period of time. Thus, the frequency of disposal of the process liquid can be decreased, which results in reduction in running costs of the process system.

In particular, whether the concentration of the process liquid in the supply tank has changed or not is judged based on a value detected by a concentration sensor that measures the concentration of the process liquid. Thus, whether the concentration of the process liquid has changed or not can be accurately judged.

Alternatively, whether the concentration of the process liquid has changed or not is judged based on an elapsed time after the process liquid was supplied to or additionally supplied to the supply tank, or an elapsed time after the solution was directly added from the solution supply source to the supply tank. Thus, without using the concentration sensor, whether the concentration of the process liquid has changed or not can be judged in a simple and convenient manner.

In addition, when it is judged that the concentration of the process liquid has changed, a predetermined amount of the process liquid in the supply tank is discarded, and then the process liquid or a solution is added to the supply tank. Thus, the addition of the process liquid or the solution can enhance a degree of amendment of the concentration of the process liquid.

Moreover, when it is judged that the concentration of the process liquid in the supply tank has changed, the process liquid is added from the blending tank to the supply tank. When the process liquid is supplied to the supply tank more than the predetermined number of times, a solution is directly added from the solution supply source to the supply tank. Thus, although the repeated supply of the process liquid from the blending tank to the supply tank degrades a degree of amendment of the concentration of the process liquid, the direct supply of the solution can enhance a degree of amendment of the concentration of the process liquid. Accordingly, the concentration of the process liquid can be maintained within a predetermined concentration range for a long period of time.

Furthermore, when a predetermined period of time has passed after the process liquid was produced in the blending tank, or the additional supply operation has been repeated more than predetermined number of times, the process liquids in the blending tank and the supply tank are discarded. Then, a process liquid is newly produced in the blending tank, and the new process liquid is supplied to be stored in the supply tank. Therefore, the concentration of the process liquid can be maintained within a predetermined concentration range for a long period of time.

### BRIEF DESCRIPTION OF THE DRAWINGS

Fig. 1 is a plan view of a layout of a process system according to the present invention;
Fig. 2 is a side view of the process system of Fig. 1;
Fig. 3 is a block diagram of a structure of a process liquid supply apparatus;
Fig. 4 is a flowchart of a process liquid supply program; and
Fig. 5 is a view schematically showing cases where, when it is judged that a concentration of a process liquid in a supply tank is changed, (a) a change in concentration of the process liquid when the process liquid is additionally supplied to the supply tank from a blending tank, and (b) a change in concentration of the process liquid when a solution is directly supplied to the supply tank from a solution supply source.

### DETAILED DESCRIPTION OF THE PREFERRED EMBODIMENT

Concrete structures of a process system and a process liquid supply method used in the process system will be described hereinbelow with reference to the drawings.

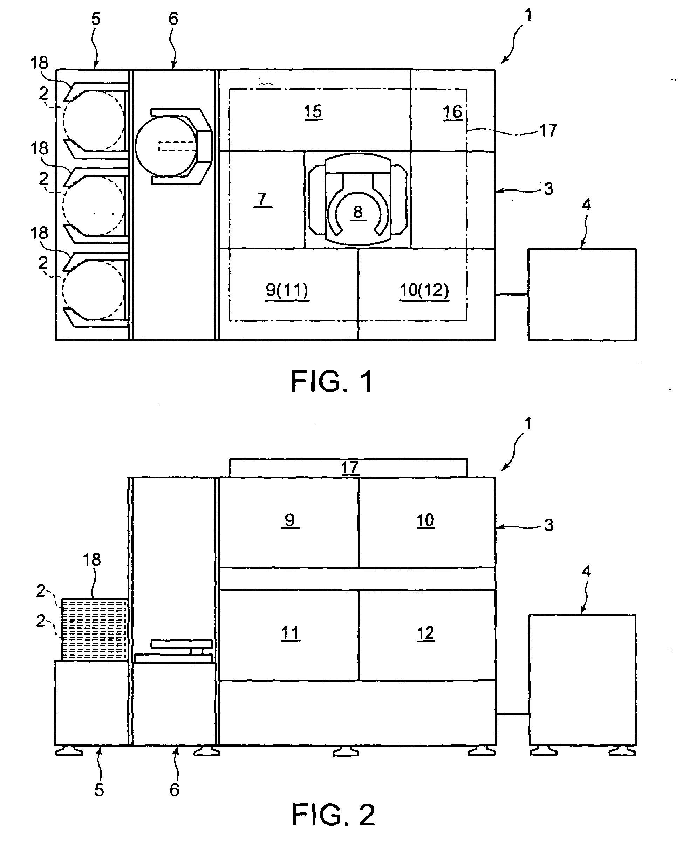

As shown in Figs. 1 and 2, a process system 1 includes: a substrate cleaning apparatus 3 for performing various processes, such as a cleaning process and drying process, to a wafer 2 as an object to be processed; and a process liquid supply apparatus 4 for supplying to the substrate cleaning apparatus 3 a process liquid (cleaning liquid) of a predetermined concentration. In the process system 1 shown in Figs. 1 and 2, although the substrate cleaning apparatus 3 and the process liquid supply apparatus 4 are separate from each other, the substrate cleaning apparatus 3 and the process liquid supply apparatus 4 may be integrally formed.

A structure of the substrate cleaning apparatus 3 is described at first. As shown in Figs. 1 and 2, the substrate cleaning apparatus 3 is provided with: a substrate loading/unloading unit 5 for loading and unloading the wafer 2; and a substrate transfer unit 6 disposed behind the substrate loading/unloading unit 6, for transferring the wafer 2 one by one. Behind the substrate transfer unit 6, there is disposed a substrate receiving/delivering unit 7 for receiving the wafer 2 and delivering the same. Behind the substrate receiving/delivering unit 7, there is disposed a main transfer unit 8 for transferring the wafer 2 inside the substrate cleaning apparatus 3. On one side of the main transfer unit 8, there are disposed substrate cleaning units 9, 10, 11, and 12 for processing the wafer 2. The cleaning units 9 and 10 are aligned with each other in a front and rear direction, and the cleaning units 11 and 12 are aligned with each other below the cleaning units 9 and 10, respectively (see, Fig 2). On the other side of the main transfer unit 8, there are disposed an electric unit 15 and a machine control unit 16 that are aligned with each other. A filter fan unit 17 is disposed above the respective units 7 to 16.

In the substrate cleaning apparatus 3, one wafer 2 is taken out by the substrate transfer unit 6 out of the plurality of wafers 2 laid on a carrier 18 placed on the substrate loading/unloading unit 5. The taken-out wafer 2 is transferred to the substrate receiving/delivering unit 7. Then, the wafer 2 is transferred by the main transfer unit 8 from the substrate receiving/delivering unit 7 to the respective substrate cleaning units 9, 10, 11, and 12 in which the wafer 2 is cleaned and dried. Thereafter, the wafer 2 is transferred by the main transfer unit 8 to the substrate receiving/delivering unit 7, and the wafer 2 is unloaded from the substrate receiving/delivering unit 7 by the substrate transfer unit 6 to the carrier 18 placed on the substrate loading/unloading unit 5.

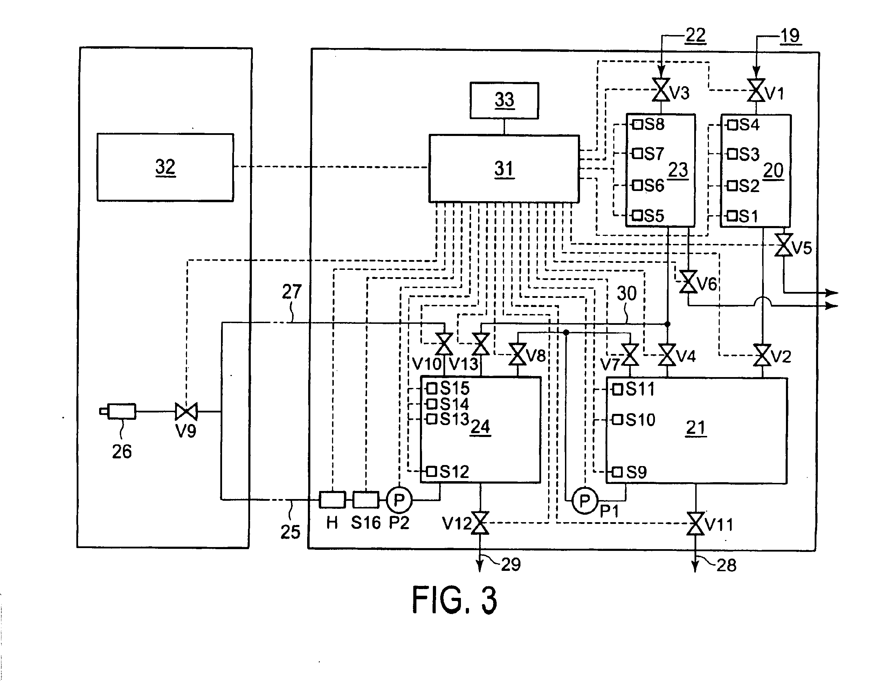

Next, a structure of the process liquid supply apparatus 4 is described. As shown in Fig. 3, in the process liquid supply apparatus 4, a weigher 20 is communicated and connected via an on-off valve V1 to a deionized water supply source 19 for supplying a deionized water. A blending tank 21 is communicated and connected to the weigher 20 via an on-off valve V2. A weigher 23 is communicated and connected via an on-off valve V3 to a chemical liquid supply source 22 for supplying a chemical liquid of a predetermined concentration. The blending tank 21 is communicated and connected to the weigher 23 via an on-off valve V4. A combination of liquids (solutions) supplied from the respective supply sources 19 and 22 is not limited to that of a chemical liquid and a deionized water, but may be a combination of various kinds of chemical liquids. It is sufficient that the supply sources 19 and 22 supply a deionized water and a chemical liquid of a predetermined concentration. The supply sources 19 and 22 may either be baths disposed outside a housing of the process system 1, or be storage tanks disposed inside the housing of the process system 1.

Level sensors S1 to S4 for detecting a liquid surface are fixed in the weigher 20, and level sensors S5 to S8 for detecting a liquid surface are fixed in the weigher 23. The lowermost level sensors S1 and S5 detect lower limit levels in the weighers 20 and 23, respectively. The uppermost level sensors S4 and S8 detect upper limit levels in the weighers 20 and 23, respectively. The level sensors S2 and S3 arranged between the level sensors S1 and S4 in the weigher 20 are used for weighing a predetermined amount of deionized water. The level sensors S6 and S7 arranged between the level sensors S5 and S8 in the weigher 23 are used for weighing a predetermined amount of chemical liquid.

On-off valves V5 and V6 for discarding liquids are connected to the weighers 20 and 23, respectively.

When the on-off valves V1 and V3 are opened with the on-off valves V5 and V6 being closed, a deionized water and a chemical liquid are supplied to the weighers 20 and 23 from the supply sources 19 and 22 respectively. After detection by the level sensors S3 and S7 (or S2 and S6) becomes ON state, the on-off valves V5 and V6 are opened and the on-off valves V1 and V3 are closed. Thereafter, when detection by the level sensors S3 and S7 (or S2 and S6) becomes OFF state, the on-off valves V5 and V6 are closed. In this manner, a weighing operation is carried out by each of the weighers 20 and 23. Depending on an amount of liquid to be weighed, it is possible to repeat the above weighing step and a supplying step to the blending tank 21. In the respective weighers 20 and 23, although a predetermined period of time elapses after detection by the level sensors S3 and S7 (or S2 and S6) became ON state, the level sensors S3 and S7 (or S2 and S6) do not become OFF state, it is judged that the weighers 20 and 23 have gone wrong.

Level sensors S9, S10, and S11 for detecting a liquid surface are fixed in the blending tank 21. Out of the level sensors S9, S10, and S11, the lowermost level sensor S9 detects a lower limit level in the bending tank 21, and the uppermost level sensor S11 detects an upper limit level in the blending tank 21. The level sensor S10 arranged between the level sensors S9 and S11 is used for weighing a deionized water.

In the process liquid supply apparatus 4, a predetermined amount of the deionized water, which has been weighed by the weigher 20, is supplied to the blending tank 21 by opening the on-off valve V2, and a predetermined amount of the chemical liquid, which has been weighed by the weigher 23, is supplied to the blending tank 21 by opening the on-off valve V4. Instead of weighing a deionized water by the weigher 20, the on-off valve V2 may be kept opened until detection by the level sensor S10 becomes ON state, so as to supply a predetermined amount of the deionized water to the blending tank 21.

In the process liquid supply apparatus 4, a pump P1 is communicated and connected to the blending tank 21 which is again communicated and connected to the pump P1 via an on-off valve 7, so that a circulation line is formed. A supply tank 24 is connected to the pump P1 via an on-off valve V8.

Level sensors S12 to S15 for detecting a liquid surface are fixed in the supply tank 24. Out of the level sensors S12 to S15, the lowermost level sensor S12 detects a lower limit level in the supply tank 24, and the uppermost level sensor S15 detects an upper limit level in the supply tank 24. The level sensor (first level sensor) S13 arranged between the level sensors S12 and S15 detects a liquid surface of a process liquid which is constantly stored in the supply tank 24. The level sensor (second level sensor) S14 arranged above the level sensor S13 detects a liquid surface of a process liquid which is added afterward to the supply tank 24.

In the process liquid supply apparatus 4, by driving the pump P1 with the on-off valve V7 being opened and the on-off valve V8 being closed, the chemical liquid and the deionized water, which have been supplied to the blending tank 21, are circulated and mixed to thereby produce a process liquid. On the other hand, by driving the pump P1 with the on-off valve V7 being closed and the on-off valve V8 being opened, the process liquid thus produced in the blending tank 21 is supplied to the supply tank 24.

In the process liquid supply apparatus 4, a pump P2 is communicated and connected to the supply tank 24, and a concentration sensor S16 for measuring a concentration of a process liquid is communicated and connected to the pump P2. A proximal end of a forward route side connection pipe 25 is communicated and connected to the concentration sensor S16 via a heater H. A process liquid outlet port (cleaning nozzle) 26 disposed on the respective substrate cleaning units 9, 10, 11, and 12 of the substrate cleaning apparatus 3 is connected to a distal end of the forward route side connection pipe 25 via an on-off valve V9. The forward route side connection pipe 25 is branched inside the substrate cleaning apparatus 3, and a proximal end of a backward route side connection pipe 27 is connected to the branched part. The supply tank 24 is communicated and connected via an on-off valve V10 to a distal end of the backward route side connection pipe 27. In the process liquid supply apparatus 4, by driving the pump P2 with the on-off valve V9 being opened and the on-off valve V10 being closed, the process liquid stored in the supply tank 24 is discharged through the process liquid outlet port 26. On the other hand, by driving the pump P2 with the on-off valve V9 being closed and the on-off valve V10 being opened, the process liquid stored in the supply tank 24 is circulated, and is maintained at an appropriate temperature by the heater H.

In the process liquid supply apparatus 4, a waste-liquid disposal pipe 28 is communicated and connected to the blending tank 21 via an on-off valve V11, and a waste-liquid disposal pipe 29 is communicated and connected to the supply tank 24 via an on-off valve V12. In the process liquid supply apparatus 4, by opening the on-off valve V11, the process liquid stored in the blending tank 21 is discarded outside through the waste-liquid disposal pipe 28. Similarly, by opening the on-off valve V12, the process liquid stored in the supply tank 24 is discarded outside through the waste-liquid disposal pipe 29.

In the process liquid supply apparatus 4, a proximal end of a supply pipe 30 is communicated and connected to the weigher 23 which is communicated and connected to the chemical liquid supply source 22, and a distal end of the supply pipe 30 is communicated and connected to the supply tank 24 via an on-off valve V13. That is, the chemical liquid supply source 22 and the supply tank 24 are directly communicated and connected to each other by way of the supply pipe 30. Thus, in the process liquid supply apparatus 4, by opening the on-off valve V13, the chemical liquid stored in the chemical liquid supply source 22 can be directly added to the supply tank 24 through the supply pipe 30, without passing through the blending tank 21. Not limited to the chemical liquid supply source 22, the deionized water supply source 19 may be directly connected to the supply tank 24.

The process liquid supply apparatus 4 houses therein a control unit 31 to which the on-off valves V1 to V13, the pumps P1 and P2, the level sensors S1 to S15, the concentration sensor S16, and the heater H are electrically connected. Thus, driving of the on-off valves V1 to V13, the pumps P1 and P2, the level sensors S1 to S15, the concentration sensor S16, and the heater H in the process liquid supply apparatus 4 are controlled by the control unit 31. The control unit 31 is connected to a control unit 32 housed in the substrate cleaning apparatus 3 such that the control units 31 and 32 can intercommunicate with each other. As described above, the control unit 31 may be separately formed from the control unit 32 housed in the substrate cleaning apparatus 3. Alternatively, the control unit 31 may be integrally formed with the control unit 32.

In the process liquid supply apparatus 4, a storage unit 33 including a program storage medium is connected to the control unit 31. The program storage medium of the storage unit 33 stores a process liquid supply program 34 for executing a supply operation of the process liquid. In accordance with the process liquid supply program 34, the process liquid supply apparatus 4 supplies the process liquid to the substrate cleaning apparatus 3, by allowing the process liquid to be discharged through the process liquid outlet port 26. The program storage medium may be built in the process liquid supply apparatus 4. Alternatively, the program storage medium may be removably fixed on a reader mounted on the process liquid supply apparatus 4, and may be readable by the reader. In the most typical case, the program storage medium is a hard disk drive in which the process liquid supply program 34 has been installed by an operator of a manufacturing company of the process system 1. In another case, the program storage medium is a removable disk such as CD-ROM or DVD-ROM in which the process liquid supply program 34 has been written. Such a removable disk is read by an optical reader disposed on the process liquid supply apparatus 4. The program storage medium may either be of a RAM (random access memory) type or a ROM (read only memory) type. Alternatively, the program storage medium may be a cassette type ROM. In short, any medium known in the technical field of a computer can be employed as the program storage medium.

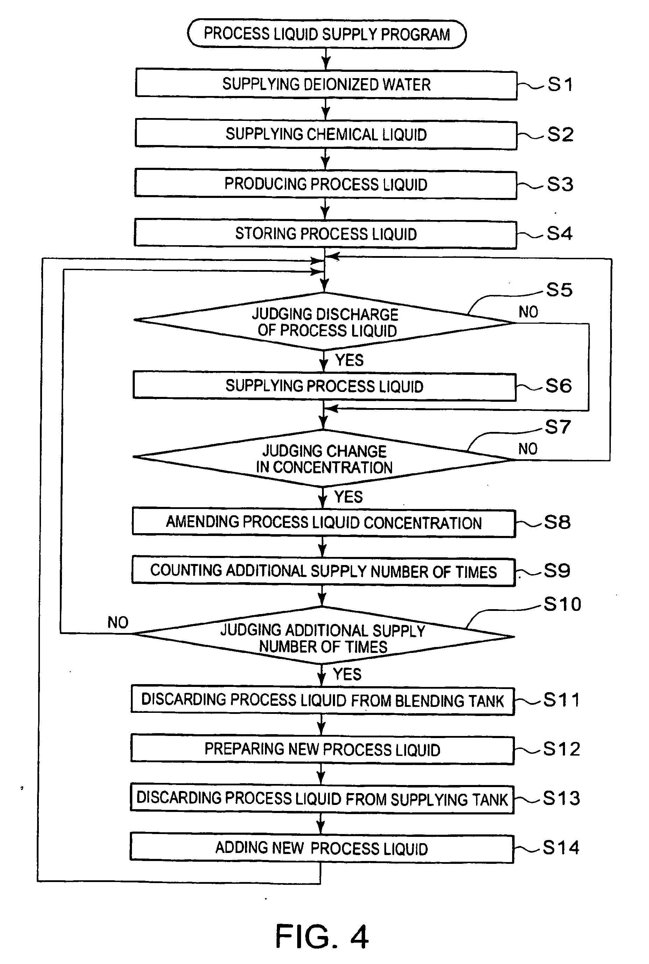

In line with the flowchart shown in Fig. 4, the process liquid supply program 34 allows the process liquid supply apparatus 4 of the above-structured process system 1 to execute a process liquid supply operation.

That is, in the process liquid supply program 34, a deionized water is supplied from the deionized water supply source 19 to the blending tank 21 (step S1 for supplying deionized water), after some initialization settings were performed.

To be specific, the control unit 31 closes the on-off valves V2 and V5, and opens the on-off valve V1 to supply a deionized water from the deionized water supply source 19 to the weigher 20. After detection by the level sensor S3 becomes ON state, the on-off valve V5 is opened while the on-off valve V1 is closed. Thereafter, when detection by the level sensor S3 becomes OFF state, the on-off valve V5 is closed, so that a predetermined amount of the deionized water is stored in the weigher 20. Then, the on-off valve V2 is opened. Thus, the predetermined amount of the deionized water, which has been weighed by the weigher 20, is supplied from the deionized water supply source 19 to the blending tank 21. Following thereto, the on-off valve V2 is closed again by the control unit 31.

Next, in the process liquid supply program 34, a chemical liquid is supplied from the chemical liquid supply source 22 to the blending tank 21 (step S2 for supplying chemical liquid).

To be specific, the control unit 31 closes the on-off valves V4 and V6, and opens the on-off valve V3 to supply a chemical liquid from the chemical liquid supply source 22 to the weigher 23. After detection by the level sensor S7 becomes ON state, the on-off valve V6 is opened while the on-off valve V3 is closed. Thereafter, when detection by the level sensor S7 becomes OFF state, the on-off valve V6 is closed, so that a predetermined amount of the chemical liquid is stored in the weigher 23. Then, the on-off valve V4 is opened. Thus, the predetermined amount of the chemical liquid, which has been weighed by the weigher 23, is supplied from the chemical liquid supply source 22 to the blending tank 21. Following thereto, the on-off valve V4 is closed again by the control unit 31.

The order of the deionized water supplying step S1 and the chemical liquid supplying step S2 may be reversed, depending on the variety of chemical liquid to be used.

Next, in the process liquid supply program 34, the chemical liquid and the deionized water are blended in the blending tank 21 to produce a process liquid (step S3 for producing process liquid).

To be specific, the control unit 31 drives the pump P1, with the on-off valve V7 being opened and the on-off valve V8 being closed. Thus, the chemical liquid and the deionized water, that have been supplied to the blending tank 21, are circulated and mixed via the pump P1 and the on-off valve V7, so that a process liquid of a predetermined concentration is produced.

Next, in the process liquid supply program 34, the process liquid prepared in the blending tank 21 is supplied to be stored in the supply tank 24 (step S4 for storing process liquid).

To be specific, the control unit 31 drives the pump P1, with the on-off valve V7 being closed and the on-off valve V8 being opened. Thereafter, when detection by the level sensor S13 becomes ON state, the on-off valve V8 is closed. Thus, the process liquid, which has been produced in the blending tank 21, is supplied to the supply tank 24. Thereafter, the control unit 31 drives the pump P1, with the on-off valve V7 being opened and the on-off valve V8 being closed, so as to circulate and mix the process liquid stored in the blending tank 21. The process liquid may be circulated and mixed constantly or periodically.

Next, in the process liquid supply program 34, it is judged whether the process liquid has to be discharged or not to the substrate cleaning apparatus 3 through the process liquid outlet port 26 (step S5 for judging discharge of process liquid).

To be specific, when the control unit 31 receives from the control unit 32 a signal commanding discharge of the process liquid, it is judged that the process liquid has to be discharged through the chemical liquid outlet port 26. On the other hand, when the control unit 31 does not receive from the control unit 32 a signal commanding discharge of the process liquid, it is judged that the process liquid does not have to be discharged through the chemical liquid outlet port 26.

Next, in the process liquid supply system 34, when it is judged that the process liquid has to be discharged, at the process liquid discharge judging step S5, the process liquid is supplied from the supply tank 24 to the process liquid outlet port 26 to discharge the process liquid therefrom (step S6 for supplying process liquid). Then, the program proceeds to a next step S7. On the other hand, when it is judged that, at the process liquid discharge judging step S5, the process liquid does not have to be discharged, the program process to the next step S7, without executing the process liquid supplying step S6.

To be specific, the control unit 31 drives the pump P2, with the on-off valve V9 being opened and the on-off valve V10 being closed. Thus, the process liquid stored in the supply tank 24 is supplied to the process liquid outlet port 26, so that the process liquid is discharged toward the wafer 2 from the process liquid outlet port 26. Thereafter, the control unit 31 drives the pump P1, with the on-off valve V7 being closed and the on-off valve V8 being opened. Then, when detection by the level sensor S13 becomes ON state, the on-off valve V8 is closed. Subsequently, the pump P2 is driven, with the on-off valve V9 being closed and the on-off valve V10 being opened, so that the process liquid stored in the supply tank 24 is circulated, and is maintained at an appropriate temperature by the heater H. The process liquid may be circulated constantly, or the process liquid may be circulated periodically.

Next, in the process liquid supply program 34, it is judged whether a concentration of the process liquid stored in the supply tank 24 has changed (step S7 for judging change in concentration).

To be specific, the control unit 31 judges whether the concentration of the process liquid stored in the supply tank 24 has changed, based on a value detected by the concentration sensor S16. That is, the control unit 31 judges that the concentration of the process liquid does not change, when the value detected by the concentration sensor S16 is within a predetermined concentration range. Meanwhile, the control unit 31 judges that the concentration of the process liquid has changed, when the value detected by the concentration sensor S16 is out of the predetermined concentration range. The concentration of the process may be increased or decreased, depending on the variety of chemical liquid.

At the concentration change judging step S7, whether the concentration of the process liquid stored in the supply tank 24 has changed or not is judged based on a value detected by the concentration sensor S16. Thus, a change in the concentration of the process liquid can be accurately judged.

Next, in the process liquid supply program 34, when it is judged that, at the concentration change judging step S7, the concentration of the process liquid stored in the supply tank 24 has changed, the concentration of the process liquid stored in the supply tank 24 is amended (step S8 for amending process liquid concentration). Then, the program proceeds to a next step S9. On the other hand, when it is judged that, at the concentration change judging step S7, the concentration of the process liquid stored in the process liquid does not change, the program returns to the process liquid discharge judging step S5, without executing the process liquid concentration amending step S8.

At the process liquid concentration amending step S8, the process liquid is added from the blending tank 21 to the supply tank 24 (step for adding process liquid).

To be specific, the control unit 31 drives the pump P1, with the on-off valve V7 being closed and the on-off valve V8 being opened. Then, when detection by the level sensor S14 becomes ON state, the on-off valve V8 is closed. Thus, the process liquid of a predetermined concentration, which has been prepared in the blending tank 21, is supplied to the supply tank 24, so that the concentration of the process liquid stored in the supply tank 24 is amended. Thereafter, the control unit 31 drives the pump P1, with the on-off valve V7 being opened and the on-off valve V8 being closed, so as to again circulate and mix the process liquid stored in the blending tank 21.

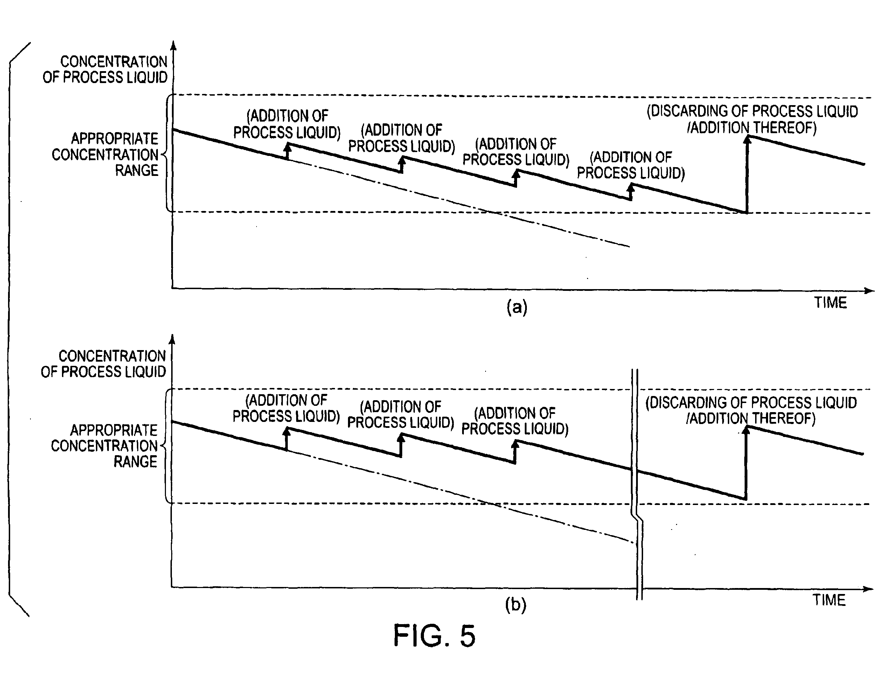

Due to the execution of the process liquid concentration amending step S8, the concentration of the process liquid stored in the supply tank 24 is amended. Thus, when the concentration of the process liquid has changed, the process operation can be continuously performed without interruption, whereby a throughput of the substrate processing step can be improved. Further, when the concentration of the process liquid has changed, the process liquid is added so that the concentration of the process liquid can be maintained within the predetermined concentration range. Thus, it is no more needed to discard the process liquid, which reduces running costs required for the substrate processing step (see, Fig. 5(a)).

At the process liquid concentration amending step S8, it is possible that, before the process liquid is additionally supplied from the blending tank 21 to the supply tank 24, the on-off valve V12 is opened for a certain period of time to discard a part of the process liquid stored in the supply tank 24, and then the process liquid is added until detection by the level sensor S13 becomes ON state.

In this case wherein, when the concentration of the process liquid stored in the supply tank 24 has changed, a predetermined amount of the process liquid is discarded and then the process liquid is added, the concentration of the process liquid can be more preferably amended by the addition of the process liquid.

Next, in the process liquid supply program 34, the number of times the process liquid is added from the blending tank 21 to the supply tank 24 based on a judgment that, at the concentration change judging step S7, the concentration of the process liquid has changed is counted for a predetermined period of time (step S9 for counting additional supply number of times).

To be specific, the control unit 31 houses a counter that counts the number of times of execution of the additional supply number of times counting step S9. With the use of a timer housed in the control unit 31, elapse of a predetermined period of time is measured. After the predetermined period of time has passed, a value counted by the counter is stored in the storage unit 33 as the additional supply number of times during the predetermined period of time. Thereafter, the counter is reset.

Next, in the process liquid supply program 34, it is judged that whether the number of times counted at the additional supply number of times counting step S9 exceeds the predetermined number of times or not (step S10 for judging additional supply number of times).

To be specific, the control unit 31 compares the additional supply number of times during the predetermined period of time which has been stored in the storage unit 33 at the additional supply number of times counting step S9, with the previously set number of times.

Next, in the process liquid supply program 34, when it is judged that, at the additional supply number of times judging step S10, the number of times the concentration of the process liquid has changed exceeds the predetermined number of times within the predetermined period of time, the process liquid stored in the blending tank 21 is discarded (step S11 for discarding process liquid from blending tank). This is because it seems difficult to maintain the concentration of the process liquid within a predetermined concentration range any more, even if the process liquid concentration amending step S8 is executed. Then, the program proceeds to next steps S12 to S14. Meanwhile, it is judged that, at the additional supply number of times judging step S10, the number of times the concentration of the process liquid has changed does not exceed the predetermined number of times within the predetermined period of time, the program returns to the process liquid discharging judging step S5.

At the step S11 for discarding process liquid from blending tank, the control unit 31 opens the on-off valve V11. Thus, the process liquid stored in the blending tank 21 is discarded outside through the waste-liquid disposal pipe 28. Thereafter, the control unit 31 closes the on-off valve V11 again.

Next, in the process liquid supply program 34, the deionized water and the chemical liquid are newly supplied from the respective supply sources 19 and 22 to the blending tank 21, and the new process liquid is prepared in the blending tank 21 (step S12 for preparing new process liquid). Herein, the deionized water supplying step S1, the chemical liquid supplying step S2, and the process liquid producing step S3 are similarly executed.

Next, in the process liquid supply program 34, the process liquid stored in the supply tank 24 is discarded (step S13 for discarding process liquid from supply tank).

To be specific, the control unit 31 opens the on-off valve V12. Thus, the process liquid stored in the supply tank 24 is discarded outside through the waste-liquid disposal pipe 29. Thereafter, the control unit 31 again closes the on-off valve V12. The step S11 for discarding liquid from blending tank and the step S13 for discarding liquid from supply tank may be simultaneously executed.

Next, in the process liquid supply program 34, the new process liquid is added from the blending tank 21 to the supply tank 24 (step S14 for adding new process liquid). Then, the program returns to the process liquid discharging judging step S5. At the new process liquid adding step S14, the process liquid storing step S4 is executed in the same manner.

Note that, when it is judged that, at the step S10 for judging additional supply number of times, the number of times the concentration of the process liquid has changed exceeds the predetermined number of times within the predetermined period of time, it is preferable to execute all the steps S11 to S14, i.e., the step S11 for discarding process liquid from blending tank, the step S12 for preparing new process liquid, the step S13 for discarding process liquid from supply tank, and the step S14 for adding new process liquid. However, not limited thereto, it is possible to selectively execute one of the following options: the step S11 for discarding process liquid from blending tank and the step S12 for preparing new process; or the step S13 for discarding process liquid from supply tank and the step S14 for adding new process liquid.

At the step S10 for judging additional supply number of times, a certain period of time is predetermined, and judgment is made based on the number of times the concentration of the process liquid has changed that is counted within the predetermined period of time. However, not limited thereto, it is possible to judge based only on the number of times the concentration of the process liquid has changed, without specifically predetermining a period of time.

Alternatively, irrespective of the number of times the concentration of the process liquid has changed, the following procedures may be executed. That is, upon elapse of a predetermined period of time (which is longer than the predetermined period of time at the additional supply number of times judging step S10) after the process liquid was produced in the blending tank 21, it is possible to respectively execute the step S11 for discarding process liquid from blending tank, the step 12 for preparing new process liquid, the step S13 for discarding process liquid from supply tank, and the step S14 for adding new process liquid, so that the process liquids in the blending tank 21 and the supply tank 24 are discarded, and the process liquid is newly produced in the blending tank 21 to supply the new process liquid to the supply tank 24.

As described above, the process liquids in the blending tank 21 and the supply tank 24 are discarded, and the process liquid is newly prepared in the blending tank 21 to supply the new process liquid to the supply tank 24, in the cases wherein a predetermined period of time has passed after the process liquid was produced in the blending tank 21, the process liquid has been added to the supply tank 24 more than the predetermined number of times, or the process liquid has been added to the supply tank more than the predetermined number of times within a predetermined period of time. Therefore, the concentration of the process liquid can be maintained within a predetermined concentration range for a long period of time (see, Fig 5(a)).

The process liquid supply program 34 has the above procedures. However, not limited thereto, the process liquid concentration amending step S8 and the concentration change judging step S7 may be altered as follows.

That is, at the process liquid concentration amending step S8, the step for adding process liquid is executed to add the process liquid from the blending tank 21 to the supply tank 24. However, a step for adding solution may be executed to directly add a solution of the chemical liquid from the chemical liquid supply source 22 to the supply tank 24.

To be specific, at the solution adding step, the control unit 31 closes the on-off valves V4 and V6 and opens the on-off valve V3, so as to supply the chemical liquid from the chemical liquid supply source 22 to the weigher 23. After detection by the level sensor S6 becomes ON state, the on-off valve V6 is opened and the on-off valve V3 is closed. Then, when the detection by the level sensor S6 becomes OFF state, the on-off valve V6 is closed, so that a predetermined amount of the chemical liquid is stored in the weigher 23. Thereafter, the on-off valve V13 is opened. Thus, without passing through the blending tank 21, the solution of the chemical liquid is directly added to the supply tank 24 through the supply pipe 30. Subsequently, the control unit 31 again closes the on-off valve V13.

In the above case wherein the solution of the chemical liquid is directly added from the chemical liquid supply source 22 to the supply tank 24 at the process liquid concentration amending step S8, the concentration of the process liquid stored in the supply tank 24 is amended. Thus, the process operation can be continuously performed when the concentration of the process liquid has changed. Therefore, interruption of the process operation can be avoided whereby a throughput of the process step can be enhanced. When the concentration of the process liquid has changed, the additional supply of the solution enables that the concentration of the process liquid can be maintained within a predetermined concentration range, which eliminates the necessity of disposal of the process liquid. Accordingly, reduction in running costs required for the substrate processing step can be achieved (see, Fig 5(b)).

In particular, at the process liquid concentration amending step S8, when the solution of the chemical liquid is directly added from the chemical liquid supply source 22 to the supply tank 24 (see, Fig. 5(b)), the concentration of the process liquid can be significantly well amended as compared with the case wherein the process liquid is added from the blending tank 21 to the supply tank 24 (see, Fig. 5(a)). In the former case, the concentration of the process liquid can be maintained within a predetermined concentration range for a longer period of time.

Alternatively, before the solution is directly added from the chemical liquid supply source 22 to the supply tank 24, the on-off valve V12 may be opened for a certain period of time to discard a part of the process liquid stored in the supply tank 24. In this case wherein, when the concentration of the process liquid in the supply tank 24 has changed, a predetermined amount of the process liquid is discarded, and then the solution is directly added to the supply tank 24, the concentration of the process liquid can be more preferably amended by the addition of the solution.

At the step of concentration change judging step S7, whether the concentration of the process liquid stored in the supply tank 24 has changed or not is judged based on a value detected by the concentration sensor S16. However, taking account that the concentration of the process liquid will change with the passage of time, which change is caused by the heater H and a natural evaporation, it may be judged whether the concentration of the process liquid stored in the supply tank 24 has changed or not, based on an elapsed time after the process liquid was added from the blending tank 21 to the supply tank 24 (after the process liquid storing step S4, the process liquid adding step, and the new process liquid adding step S14 were executed), or an elapsed time after the solution was added from the chemical liquid supply source 22 to the supply tank 24 (after the solution adding step was executed).

To be specific, when the process liquid storing step S4, the process liquid adding step, and the new process liquid adding step S14 are executed, the timer housed in the control unit 31 is reset, and a time thereafter is measured by the timer. After a predetermined period of time has passed, it is presumed and judged that the concentration of the process liquid has changed. The predetermined period of time is determined on the basis of a concentration change property of the process liquid when the process liquid is additionally supplied, which property is previously measured.

Alternatively, when the solution adding step is executed, the timer housed in the control unit 31 is reset, and a time thereafter is measured by the timer. After a predetermined period of time has passed, it is presumed and judged that concentration of the process liquid has changed. The predetermined period of time is determined on the basis of a concentration change property of the process liquid when the process liquid is additionally supplied, which property is previously measured.

In these case wherein whether the concentration of the process liquid stored in the supply tank 24 has changed or not is judged based on an elapsed time after the process liquid was added from the blending tank 21 to the supply tank 24, or an elapsed time after the solution of the chemical liquid was added from the chemical liquid supply source 22 to the supply source, there is no need for providing the process liquid supply apparatus 4 with the concentration sensor S16. Thus, the structure of the process liquid supply apparatus 4 can be simplified. In this manner, without using the concentration sensor S16, whether the concentration of the process liquid has changed or not can be judged in a simple and convenient manner.

The process liquid concentration amending step S8 may be executed in the following manner. First, the process liquid adding step is executed to add the process liquid from the blending tank 21 to the supply tank 24. Thereafter, when the process liquid supplying step has been executed more than the predetermined number of times, the solution adding step is executed to directly add the solution of the chemical liquid from the chemical liquid supply source 22 to the supply tank 24.

When the process liquid is repeatedly added from the blending tank 21 to the supply tank 24, amendment of the concentration of the process liquid is gradually degraded. However, since the direct addition of the stock liquid contributes to improvement in amendment of the concentration of the process liquid, the concentration of the process liquid can be maintained within a predetermined concentration range for a long period of time.

Given in the above embodiment as an example to describe the process is a case wherein the solution of the chemical liquid is directly added. However, when the concentration of the process liquid is not lowered but raised, the deionized water may be directly added.

## Claims

1. A process system comprising:
a plurality of solution supply sources (19, 22);
a blending tank (21) to be supplied with solutions from the respective solution supply sources (19, 22), and operable to blend the solutions to produce a process liquid of a predetermined concentration;
a supply tank (24) that is connected to the blending tank (21) operable to store therein the process liquid supplied from the blending tank (21);
a process liquid supply adjusting valve (V8) disposed between the blending tank and the supply tank, operable to adjust a flow of the process liquid from the blending tank (21) to the supply tank (24); and
a process liquid discharge port (26, V9; 27) to be supplied with process liquid supplied from the supply tank (24), and operable to discharge the process liquid toward an object to be processed;
the system being **characterized by** comprising:
a concentration sensor (S16) configured to measure the concentration of the process liquid in the supply tank (24) wherein
the control unit (31) is configured to judge whether the concentration of the process liquid has changed or not, based on the concentration of the process liquid measured by the concentration sensor (S16), and
a control unit (31) configured to control the process liquid supply adjusting valve (V8) to additionally supply the process liquid from the blending tank (21) to the supply tank (24) at the time of being judged by the judging unit that the concentration of the process liquid in the supply tank has changed.

2. The process system according to claim 1, wherein
the control unit (31) is operable to judge that the concentration of the process liquid in the supply tank (24) has changed, when a predetermined period of time has elapsed after the flow of the process liquid from the blending tank (21) to the supply tank (24) was stopped by the process liquid supply adjusting valve (V8).

3. The process system according to claim 1, wherein
the supply tank (24) is provided with a level sensor (S12 to S15) operable to detect that a liquid surface level of the process liquid stored in the supply tank reaches a predetermined level; and
the control unit is operable to control such that a predetermined amount of the process liquid in the supply tank (24) is discarded and to control the process liquid supply adjusting valve (V8) such that the process liquid is supplied from the blending tank (21) to the supply tank (24) until the level sensor (S12 to S15) detects that the liquid surface level of the process liquid reaches the predetermined level, when it is judged by the control unit (31) that the concentration of the process liquid in the supply tank (24) has changed.

4. The process system according to claim 1 further comprising:
a solution supply line (30) that connects the solution supply source (22) and the supply tank (24) to each other;
a solution supply adjusting valve (V13) disposed on the solution supply line (30), and operable to adjust a flow of the solution from the solution supply source (22) to the supply tank (24);
wherein the control unit (31) is operable to control the solution supply adjusting valve (V13) such that, when the number of times the process liquid is additionally supplied from the blending tank (21) to the supply tank (24) reaches the predetermined number of times, the solution is directly supplied from the solution supply source (22) to the supply tank (24).

5. The process system according to claim 1, wherein the control unit (31) is operable to control such that the process liquids in the blending tank (21) and the supply tank (24) are discarded and to control such that the process liquid is newly produced in the blending tank (21) to supply the new process liquid to the supply tank (24), when a predetermined period of time has elapsed after the process liquid was produced in the blending tank.

6. The process system according to claim 1, wherein
the control unit (31) is operable to control such the process liquids in the blending tank (21) and the supply tank (24) are discarded and to control such that the process liquid is newly produced in the blending tank (21) to supply the new process liquid to the supply tank (24), when the number of times the process liquid is additionally supplied from the blending tank (21) to the supply tank (24) reaches the predetermined number of times.

7. A process liquid supply method comprising the steps of:
producing a process liquid of a predetermined concentration in a blending tank (21) by blending solutions respectively supplied from a plurality of solution supply sources (19, 22);
supplying the process liquid from the blending tank (21) to a supply tank (24) to store therein the process liquid; and
discharging the process liquid from a process liquid discharge port (26) toward an object to be processed, by supplying the process liquid to the process liquid discharge port (26);
the method being **characterized by** comprising the steps of:
judging whether a concentration of the process liquid in the supply tank (24) has changed or not; and
supplying additionally the process liquid from the blending tank (21) to the supply tank, when it is judged that the concentration of the process liquid in the supply tank (24) has changed, the step of providing a concentration sensor (S16) that measures the concentration of the process liquid in the supply tank (24), wherein
whether the concentration of the process liquid has changed or not is judged based on the concentration of the process liquid measured by the concentration sensor (S16).

8. The process liquid supply method according to claim 7, wherein
when a predetermined period of time has elapsed after a flow of the process liquid from the blending tank (21) to the supply tank (24) is stopped, it is judged that the concentration of the process liquid in the supply tank (24) has changed.

9. The process liquid supply method according to claim 7, wherein
when it is judged that the concentration of the process liquid in the supply tank (24) has changed, a predetermined amount of the process liquid in the supply tank (24) is discharged, and the process liquid is additionally supplied from the blending tank (21) to the supply tank (24).

10. The process liquid supply method according to claim 7, wherein
when the number of times the process liquid is additionally supplied from the blending tank (21) to the supply tank (24) reaches the predetermined number of times, the solution is directly supplied from the solution supply source (22) to the supply tank (24).

11. The process liquid supply method according to claim 7, wherein
when a predetermined period of time has elapsed after the process liquid was produced in the blending tank (21), the process liquids in the blending tank (21) and the supply tank (24) are discarded, and the process liquid is newly produced in the blending tank (21) to supply the new process liquid to the supply tank (24).

12. The process liquid supply method according to claim 7, wherein
when the number of times the process liquid is additionally supplied from the blending tank (21) to the supply tank (24) reaches the predetermined number of times, the process liquids in the blending tank (21) and the supply tank (24) are discarded, and the process liquid is newly produced in the blending tank (21) to supply the new process liquid to the supply tank.

## Patentansprüche

1. Prozesssystem, mit:
einer Vielzahl von Lösungszuführungsquellen (19, 22);
einem Mischtank (21), dem Lösungen von den jeweiligen Lösungszuführungsquellen (19, 22) zuzuführen sind, und der betriebsfähig ist, um die Lösungen zu mischen, um eine Prozessflüssigkeit mit einer vorbestimmten Konzentration zu produzieren;
einem Versorgungstank (24), der mit dem Mischtank (21) verbunden ist, wobei er betriebsfähig ist, um in ihm die von dem Mischtank (21) zugeführte Prozessflüssigkeit zu lagern;
einem Prozessflüssigkeitszuführungs-Einstellventil (V8), das zwischen dem Mischtank und dem Versorgungstank angeordnet ist, wobei es betriebsfähig ist, um einen Fluss der Prozessflüssigkeit von dem Mischtank (21) zu dem Versorgungstank (24) anzupassen; und
einer Prozessflüssigkeits-Ablauföffnung (26, V9; 27), der von dem Versorgungstank (24) zugeführte Prozessflüssigkeit zuzuführen ist, und die betriebsfähig ist, um die Prozessflüssigkeit zu einem zu verarbeitenden Objekt hin abzulassen;
wobei das System **dadurch gekennzeichnet ist, dass** es umfasst:
einen Konzentrationssensor (S16), der ausgestaltet ist, um die Konzentration der Prozessflüssigkeit in dem Versorgungstank (24) zu messen, wobei
die Steuereinheit (31) ausgestaltet ist, um zu beurteilen, ob sich die Konzentration der Prozessflüssigkeit geändert hat oder nicht, basierend auf der Konzentration der durch den Konzentrationssensor (S16) gemessenen Prozessflüssigkeit, und
eine Steuereinheit (31), die ausgestaltet ist, um das Prozessflüssigkeitszuführungs-Einstellventil (V8) zu steuern, um zusätzlich die Prozessflüssigkeit von dem Mischtank (21) zu dem Versorgungstank (24) zuzuführen, zu dem Zeitpunkt des Beurteilens durch die Beurteilungseinheit, dass sich die Konzentration der Prozessflüssigkeit in dem Versorgungstank geändert hat.

2. Prozesssystem nach Anspruch 1, wobei
die Steuereinheit (31) betriebsfähig ist, um zu beurteilen, dass sich die Konzentration der Prozessflüssigkeit in dem Versorgungstank (24) geändert hat, wenn ein vorbestimmter Zeitraum vergangen ist, nachdem der Fluss der Prozessflüssigkeit von dem Mischtank (21) zu dem Versorgungstank (24) durch das Prozessflüssigkeitszuführungs-Einstellventil (V8) angehalten wurde.

3. Prozesssystem nach Anspruch 1, wobei
der Versorgungstank (24) mit einem Pegelsensor (S12 bis S15) versehen ist, der betriebsfähig ist, um zu erfassen, dass ein Flüssigkeitsoberflächenpegel der in dem Versorgungstank gelagerten Prozessflüssigkeit einen vorbestimmten Pegel erreicht; und
die Steuereinheit betriebsfähig ist, um derart zu steuern, dass eine vorbestimmte Menge der Prozessflüssigkeit in dem Versorgungstank (24) ausgeschieden wird, und das
Prozessflüssigkeitszuführungs-Einstellventil (V8) derart zu steuern, dass die Prozessflüssigkeit von dem Mischtank (21) zu dem Versorgungstank (24) zugeführt wird bis der Pegelsensor (S12 bis S15) erfasst, dass der Flüssigkeitsoberflächenpegel der Prozessflüssigkeit den vorbestimmten Pegel erreicht, wenn durch die Steuereinheit (31) beurteilt wird, dass sich die Konzentration der Prozessflüssigkeit in dem Versorgungstank (24) geändert hat.

4. Prozesssystem nach Anspruch 1, ferner mit:
einer Lösungszuführungsleitung (30), welche die Lösungszuführungsquelle (22) und den Versorgungstank (24) miteinander verbindet;
einem Lösungszuführungs-Einstellventil (V13), das an der Lösungszuführungsleitung (30) angeordnet ist, und wobei es betriebsfähig ist, um einen Fluss der Lösung von der Lösungszuführungsquelle (22) zu dem Versorgungstank (24) anzupassen;
wobei die Steuereinheit (31) betriebsfähig ist, um das Lösungszuführungs-Einstellventil (V13) derart zu steuern, dass, wenn die Anzahl von Malen, welche die Prozessflüssigkeit zusätzlich von dem Mischtank (21) zu dem Versorgungstank (24) zugeführt wird, die vorbestimmte Anzahl von Malen erreicht, die Lösung direkt von der Lösungszuführungsquelle (22) zu dem Versorgungstank (24) zugeführt wird.

5. Prozesssystem nach Anspruch 1, wobei
die Steuereinheit (31) betriebsfähig ist, um derart zu steuern, dass die Prozessflüssigkeiten in dem Mischtank (21) und dem Versorgungstank (24) ausgeschieden werden, und um derart zu steuern, dass die Prozessflüssigkeit erneut in dem Mischtank (21) produziert wird, um die neue Prozessflüssigkeit dem Versorgungstank (24) zuzuführen, wenn ein vorbestimmter Zeitraum vergangen ist, nachdem die Prozessflüssigkeit in dem Mischtank produziert wurde.

6. Prozesssystem nach Anspruch 1, wobei
die Steuereinheit (31) betriebsfähig ist, um derart zu steuern, dass die Prozessflüssigkeiten in dem Mischtank (21) und dem Versorgungstank (24) ausgeschieden werden, und um derart zu steuern, dass die Prozessflüssigkeit erneut in dem Mischtank (21) produziert wird, um die neue Prozessflüssigkeit dem Versorgungstank (24) zuzuführen, wenn die Anzahl von Malen, welche die Prozessflüssigkeit zusätzlich von dem Mischtank (21) zu dem Versorgungstank (24) zugeführt wird, die vorbestimmte Anzahl von Malen erreicht.

7. Prozessflüssigkeits-Zuführungsverfahren, die folgenden Schritte umfassend:
Produzieren einer Prozessflüssigkeit mit einer vorbestimmten Konzentration in einem Mischtank (21) durch Mischen von Lösungen, die jeweils von einer Vielzahl von Lösungszuführungsquellen (19, 22) zugeführt werden;
Zuführen der Prozessflüssigkeit von dem Mischtank (21) zu einem Versorgungstank (24), um in ihm die Prozessflüssigkeit zu lagern; und
Ablassen der Prozessflüssigkeit aus einer Prozessflüssigkeits-Ablauföffnung (26) zu einem zu verarbeitenden Objekt hin, durch Zuführen der Prozessflüssigkeit zu der Prozessflüssigkeits-Ablauföffnung (26);
wobei das Verfahren **dadurch gekennzeichnet ist, dass** es die Schritte umfasst:
Beurteilen, ob sich eine Konzentration der Prozessflüssigkeit in dem Versorgungstank (24) geändert hat oder nicht; und
zusätzliches Zuführen der Prozessflüssigkeit von dem Mischtank (21) zu dem Versorgungstank, wenn beurteilt wird, dass sich die Konzentration der Prozessflüssigkeit in dem Versorgungstank (24) geändert hat, den Schritt des Bereitstellens eines Konzentrationssensors (S16), der die Konzentration der Prozessflüssigkeit in dem Versorgungstank (24) misst, wobei
ob sich die Konzentration der Prozessflüssigkeit geändert hat oder nicht, basierend auf der Konzentration der durch den Konzentrationssensor (S16) gemessenen Prozessflüssigkeit beurteilt wird.

8. Prozessflüssigkeits-Zuführungsverfahren nach Anspruch 7, wobei
wenn ein vorbestimmter Zeitraum vergangen ist, nachdem ein Fluss der Prozessflüssigkeit von dem Mischtank (21) zu dem Versorgungstank (24) angehalten wurde, es beurteilt wird, dass sich die Konzentration der Prozessflüssigkeit in dem Versorgungstank (24) geändert hat.

9. Prozessflüssigkeits-Zuführungsverfahren nach Anspruch 7, wobei
wenn beurteilt wird, dass sich die Konzentration der Prozessflüssigkeit in dem Versorgungstank (24) geändert hat, eine vorbestimmte Menge der Prozessflüssigkeit in dem Versorgungstank (24) abgelassen wird, und wobei die Prozessflüssigkeit von dem Mischtank (21) zu dem Versorgungstank (24) zusätzlich zugeführt wird.

10. Prozessflüssigkeits-Zuführungsverfahren nach Anspruch 7, wobei
wenn die Anzahl von Malen, welche die Prozessflüssigkeit von dem Mischtank (21) zu dem Versorgungstank (24) zusätzlich zugeführt wird, die vorbestimmte Anzahl von Malen erreicht, die Lösung von der Lösungszuführungsquelle (22) zu dem Versorgungstank (24) direkt zugeführt wird.

11. Prozessflüssigkeits-Zuführungsverfahren nach Anspruch 7, wobei
wenn ein vorbestimmter Zeitraum vergangen ist, nachdem die Prozessflüssigkeit in dem Mischtank (21) produziert wurde, die Prozessflüssigkeiten in dem Mischtank (21) und dem Versorgungstank (24) ausgeschieden werden, und wobei die Prozessflüssigkeit in dem Mischtank (21) erneut produziert wird, um die neue Prozessflüssigkeit dem Versorgungstank (24) zuzuführen.

12. Prozessflüssigkeits-Zuführungsverfahren nach Anspruch 7, wobei
wenn die Anzahl von Malen, welche die Prozessflüssigkeit von dem Mischtank (21) zu dem Versorgungstank (24) zusätzlich zugeführt wird, die vorbestimmte Anzahl von Malen erreicht, die Prozessflüssigkeiten in dem Mischtank (21) und dem Versorgungstank (24) ausgeschieden werden, und wobei die Prozessflüssigkeit in dem Mischtank (21) erneut produziert wird, um die neue Prozessflüssigkeit dem Versorgungstank zuzuführen.

## Revendications

1. Système de traitement comprenant:
une pluralité de sources (19, 22) d'alimentation en solutions;
un réservoir de mélange (21) à alimenter en solutions à partir des sources (19, 22) d'alimentation en solutions respectives, et pouvant fonctionner pour mélanger les solutions afin de produire un liquide de traitement d'une concentration prédéterminée;
un réservoir d'alimentation (24) qui est relié au réservoir de mélange (21) pouvant fonctionner pour y stocker le liquide de traitement alimenté depuis le réservoir de mélange (21);
une soupape (V8) de régulation d'alimentation en liquide de traitement disposée entre le réservoir de mélange et le réservoir d'alimentation, pouvant fonctionner pour réguler l'écoulement du liquide de traitement depuis le réservoir de mélange (21) au réservoir d'alimentation (24); et
un orifice (26, V9; 27) de décharge du liquide de traitement à alimenter en liquide de traitement alimenté depuis le réservoir d'alimentation (24), et pouvant fonctionner pour décharger le liquide de traitement vers un objet à traiter;
le système étant **caractérisé par** le fait de comprendre :
un capteur de concentration (S 16) configuré pour mesurer la concentration du liquide de traitement dans le réservoir d'alimentation (24), dans lequel
une unité de commande (31) configurée pour estimer si la concentration du liquide de traitement a changé ou pas, sur la base de la concentration du liquide de traitement mesurée par le capteur de concentration (S 16), et
l'unité de commande (31) est configurée pour commander la soupape (V8) de régulation d'alimentation en liquide de traitement pour alimenter en plus le liquide de traitement depuis le réservoir de mélange (21) au réservoir d'alimentation (24) au moment où l'unité d'estimation estime que la concentration du liquide de traitement dans le réservoir d'alimentation a changé.

2. Système de traitement selon la revendication 1, dans lequel l'unité de commande (31) peut fonctionner pour estimer que la concentration du liquide de traitement dans le réservoir d'alimentation (24) a changé, lorsqu'une période de temps prédéterminée s'est écoulée après que l'écoulement du liquide de traitement depuis le réservoir de mélange (21) au réservoir d'alimentation (24) a été arrêté par la soupape (V8) de régulation d'alimentation en liquide de traitement.

3. Système de traitement selon la revendication 1, dans lequel le réservoir d'alimentation (24) est doté d'un capteur de niveau (S 12 à S15) pouvant fonctionner pour détecter qu'un niveau de surface de liquide du liquide de traitement stocké dans le réservoir d'alimentation atteint un niveau prédéterminé; et
l'unité de commande peut fonctionner pour commander, de telle sorte qu'une quantité prédéterminée du liquide de traitement dans le réservoir d'alimentation (24) soit rejetée et pour commander la soupape (V8) de régulation d'alimentation en liquide de traitement de telle sorte que le liquide de traitement soit alimenté depuis le réservoir de mélange (21) au réservoir d'alimentation (24) jusqu'à ce que le capteur de niveau (S 12 à S 15) détecte que le niveau de surface de liquide du liquide de traitement atteint le niveau prédéterminé, lorsque l'unité de commande (31) estime que la concentration du liquide de traitement dans le réservoir d'alimentation (24) a changé.

4. Système de traitement selon la revendication 1 comprenant en plus:
une voie (30) d'alimentation en solutions qui relie la source (22) d'alimentation en solutions au réservoir d'alimentation (24);
une soupape (V13) de régulation d'alimentation en solutions disposée sur la voie (30) d'alimentation en solutions, et pouvant fonctionner pour réguler un écoulement de la solution depuis la source (22) d'alimentation en solutions au réservoir d'alimentation (24);
où l'unité de commande (31) peut fonctionner pour commander la soupape (V13) de régulation d'alimentation en solutions de telle sorte que, lorsque le nombre de fois que le liquide de traitement est alimenté en plus depuis le réservoir de mélange (21) au réservoir d'alimentation (24) atteint le nombre de fois prédéterminé, la solution est directement alimentée depuis la source (22) d'alimentation en solutions au réservoir d'alimentation (24).

5. Système de traitement selon la revendication 1, dans lequel l'unité de commande (31) peut fonctionner pour commander, de telle sorte que les liquides de traitement dans le réservoir de mélange (21) et le réservoir d'alimentation (24) soient rejetés et pour commander de telle sorte que le liquide de traitement soit nouvellement produit dans le réservoir de mélange (21) pour alimenter le nouveau liquide de traitement au réservoir d'alimentation (24), lorsqu'une période de temps prédéterminée s'est écoulée après la production du liquide de traitement dans le réservoir de mélange.

6. Système de traitement selon la revendication 1, dans lequel l'unité de commande (31) peut fonctionner pour commander de telle sorte que les liquides de traitement dans le réservoir de mélange (21) et le réservoir d'alimentation (24) soient rejetés et pour commander de telle sorte que le liquide de traitement soit nouvellement produit dans le réservoir de mélange (21) pour alimenter le nouveau liquide de traitement au réservoir d'alimentation (24), lorsque le nombre de fois que le liquide de traitement est alimenté en plus depuis le réservoir de mélange (21) au réservoir d'alimentation (24) atteint le nombre de fois prédéterminé.

7. Procédé d'alimentation en liquide de traitement comprenant les étapes consistant à:
produire un liquide de traitement d'une concentration prédéterminée dans un réservoir de mélange (21) en mélangeant des solutions respectivement alimentées depuis une pluralité de sources (19, 22) d'alimentation en solutions;
alimenter le liquide de traitement depuis le réservoir de mélange (21) au réservoir d'alimentation (24) pour y stocker le liquide de traitement; et
décharger le liquide de traitement depuis un orifice (26) de décharge du liquide de traitement vers un objet à traiter, en alimentant le liquide de traitement à l'orifice (26) de décharge du liquide de traitement;
le procédé étant **caractérisé par** le fait de comprendre les étapes consistant à:
estimer si une concentration du liquide de traitement dans le réservoir d'alimentation (24) a changé ou pas; et
alimenter en plus le liquide de traitement depuis le réservoir de mélange (21) au réservoir d'alimentation, lorsqu'il est estimé que la concentration du liquide de traitement dans le réservoir d'alimentation (24) a changé,
l'étape consistant à fournir un capteur de concentration (S 16) qui mesure la concentration du liquide de traitement dans le réservoir d'alimentation (24); où
l'on estime si la concentration du liquide de traitement a changé ou pas sur la base de la concentration du liquide de traitement mesurée par le capteur de concentration (S 16).

8. Procédé d'alimentation en liquide de traitement selon la revendication 7, dans lequel
lorsqu'une période de temps prédéterminée s'est écoulée après qu'un écoulement du liquide de traitement depuis le réservoir de mélange (21) au réservoir d'alimentation (24) s'est arrêté, il est estimé que la concentration du liquide de traitement dans le réservoir d'alimentation (24) a changé.

9. Procédé d'alimentation en liquide de traitement selon la revendication 7, dans lequel
lorsqu'il est estimé que la concentration du liquide de traitement dans le réservoir d'alimentation (24) a changé, une quantité prédéterminée du liquide de traitement dans le réservoir d'alimentation (24) est déchargée, et le liquide de traitement est alimenté en plus depuis le réservoir de mélange (21) au réservoir d'alimentation (24).

10. Procédé d'alimentation en liquide de traitement selon la revendication 7, dans lequel
lorsque le nombre de fois que le liquide de traitement est alimenté en plus depuis le réservoir de mélange (21) au réservoir d'alimentation (24) atteint le nombre de fois prédéterminé, la solution est directement alimentée depuis la source (22) d'alimentation en solutions au réservoir d'alimentation (24).

11. Procédé d'alimentation en liquide de traitement selon la revendication 7, dans lequel
lorsqu'une période de temps prédéterminée s'est écoulée après la production du liquide de traitement dans le réservoir de mélange (21), les liquides de traitement dans le réservoir de mélange (21) et le réservoir d'alimentation (24) sont rejetés, et le liquide de traitement est nouvellement produit dans le réservoir de mélange (21) pour alimenter le nouveau liquide de traitement au réservoir d'alimentation (24).

12. Procédé d'alimentation en liquide de traitement selon la revendication 7, dans lequel
lorsque le nombre de fois que le liquide de traitement est alimenté en plus depuis le réservoir de mélange (21) au réservoir d'alimentation (24) atteint le nombre de fois prédéterminé, les liquides de traitement dans le réservoir de mélange (21) et le réservoir d'alimentation (24) sont rejetés, et le liquide de traitement est nouvellement produit dans le réservoir de mélange (21) pour alimenter le nouveau liquide de traitement au réservoir d'alimentation.
